# EUROPEAN PATENT APPLICATION

(11) **EP 0 877 452 A2**
(43) Date of publication of application: **11.11.1998**
(21) Application number: 98303557.7
(22) Date of filing: 06.05.1998
(51) Int. Cl.: H01S 3/025, H01L 33/00, H01L 23/13

(54) **Laser sub-mount**

(30) Priority: 07.05.1997 GB 9709096
(71) Applicant: Mitel Semiconductor AB, 175 26 Järfälla (SE)
(72) Inventor: Wickström, Mikael, 17770 Jarfalla (SE); Oskarsson, Vilhelm, 17561 Jarfalla (SE)
(74) Representative: Harding, Richard Patrick

(57) **Abstract**

A method of manufacturing substrates for laser diodes and similar opto-electronic devices. The substrates have a bi-level configuration with at least two isolated metal contacts extending continuously between the two surfaces. The method permits mass production of such substrate from a plate of substrate material. A substrate resulting from the method is also described.

## Description

### Field of the Invention

This invention relates to a sub-mount structure for devices such as edge emitting light sources and fiber optical assemblies and more particularly to miniature, bi-level substrates having isolated electrical contacts.

### Background

Many small-scale devices in the electronic industry require a bi-level architecture wherein continuous metalization extends between the two levels while providing at least two isolated contact pads for mounting and bonding purposes. It is difficult to manufacture such small-scale substrates on an economical, high volume basis. Structures suitable for device attachment such as by soldering or conductive adhesives require good quality metal surfaces that can withstand relatively high temperatures. It is common for such structures to have metal on three sides.

Thick film techniques tend not to be sufficiently accurate to produce isolated contacts on substrates of approximately 1 mm by 1 mm by 1 mm.

It is known to screen print thick film materials such that the paste flows over the edge and makes a continuous electrical contact. This method involves the individual handling of each substrate. It is also known to use thin film solutions but these are very costly and not practical for high-volume manufacturing processes.

### Summary of the Invention

It is an object of the present invention to provide a method of mass-producing small, bi-level substrate units having isolated metal contacts.

Therefore, in accordance with a first aspect of the present invention there is provided a method of forming a substrate with isolated metalized pads. The method comprises: forming a first channel into the top surface of a plate of substrate material; metalizing the top surface and the channel including bottom and side walls thereof; forming at least a second channel into the top surface, the second channel crossing the first channel and extending into the plate to a depth greater than the first channel; and separating the substrate from the plate of substrate material.

According to a second aspect of the present invention there is provided a bi-level substrate having isolated metal pads. The substrate has a top surface, a bottom surface and opposed side walls, one of the side walls having a lateral step with an upper surface substantially parallel to the substrate top surface. The substrate has a channel perpendicular to the lateral step extending from the top surface to below the upper surface of the lateral step; and metalization on the top surface of the substrate, the upper surface of the lateral step and on the side wall therebetween.

### Brief Description of the Drawings

The invention will now be described in greater detail with reference to the attached drawings wherein:
Figure 1 is a perspective view of one embodiment of the present invention;
Figure 2 is a perspective view of a second embodiment of the invention; and
Figure 3 illustrates an alternate substrate structure.

### Detailed Description of the Invention

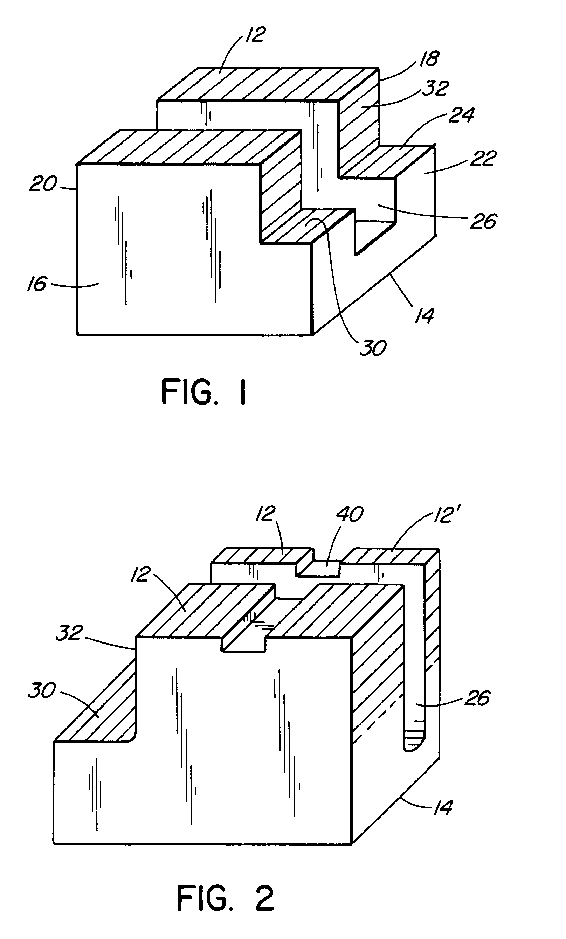

Figure 1 illustrates the basic structure of the substrate according to the present invention. The substrate, of a well-known non-conducting substrate material such as ceramic, has top surface 12, bottom surface 14, opposed side walls 16, 18, 20 and 22. Lateral step 24 is located in side wall 22. Channel 26, as shown in Figure 1, is perpendicular to the lateral step and extends from the top surface to a depth greater than the upper surface 30 of the lateral step 24.

Metalization such as gold, a gold alloy or other conducting materials covers the top surface 12 of the substrate as well as the surface 24 of the lateral step and side wall 32 extending from the top surface to the upper surface of the side step.

As will be apparent from Figure 1 a semi-conductor device such as an edge emitting laser or light emitting diode (not shown) can be mounted on the metal layer on either side of channel 26. The device may be mounted either on the top surface or the upper surface of the lateral step. As is well known, edge emitting devices have metalized layers on both top and bottom faces which are on either side of the p-n junction of the light emitting device. One of these faces will be bonded to one of the metal pads and the opposite metalized face is connected to the separate pad by well-known bonding techniques. Further contacts can then be bonded between the metal pads and a lead frame or other connector means to allow for energizing the light emitting device.

The substrate of Figure 1 has been separated from a plate of the substrate material which, as indicated previously, may be ceramic or a similar non-conducting material. In manufacture, a plate of the substrate material is provided with channels or slots which extend to a selected depth into the substrate material. These channels or slots may be formed by sawing such as with a thin-bladed diamond saw. It is contemplated that a ganged array of saw-blades having a predefined spacing can be used to simultaneously cut several channels in a plate of the ceramic material. In addition to a diamond saw the slots or channel can be formed by other means such as a reciprocating wire saw, a sand blaster or a laser. As will be apparent the width of the slot or channel will depend on the application and the method chosen to form it. As an example the width for a diamond saw can be as narrow as 30um.

The plate is then metalized by, for example, sputtering such that the metal (such as gold or gold alloy) is deposited on the upper surface of the substrate material and into the channels including the side walls and bottom. In addition to sputtering the metal layer may be applied by other methods such as evaporation, electroplating, electroless plating, metal spraying and chemical vapour deposition (CVD).

The plate is then cut again such that a substantial portion of the bottom face of the channel remains attached to the strip so as to provide lateral step 24. The resulting long, narrow strips are then cut a second time with the second cut running substantially perpendicular to the step; the second cut extending below the upper surface of the step to thereby electrically isolate the two metal contact pads. The strip is then cut into individual substrates of the type shown in Figure 1. It is also possible that the separation cuts do not go all the way through the plate so that the long strip can be kept intact during device mounting and testing etc. Individual units with mounted and bonded devices are then snapped from the long strip for assembly.

In certain applications it will be desirable to have metalization on the bottom face as well and this step may be carried out before or after the top face has been metalized.

An alternate embodiment of the invention is shown in Figure 2. The structure is similar to that which is shown in Figure 1 except that a third channel or slot 40 is made in the upper surface of the substrate.

This further isolates the metalization in order to provide additional isolated metal pads 12, 12¹ which may be used for connecting detectors, optical amplifiers or other micro-electronic devices.

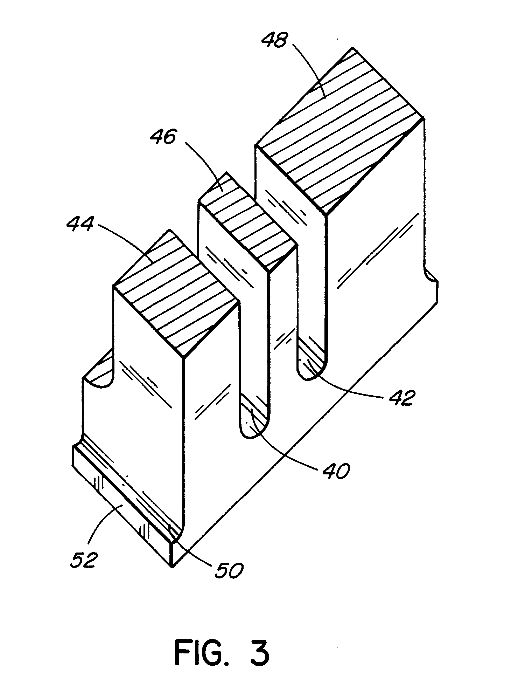

As will be apparent to one skilled in the art, the method according to the present invention can be readily applied to the manufacture of substrates having different shapes and dimensions, as well as a variety of shapes and quantity of isolated metal bonding/mounting pads. Figure 3 shows another example of a substrate having isolated metal connectors which are continuous over the edge from the top surface to the upper surface of the lateral step. In Figure 3 channels 40 and 42 isolate metal pads 44, 46 and 48. Figure 3 also shows at 50 the bottom of separation cut which did not go completely through the substrate in manufacture. The substrate was subsequently broken from the previously discussed strip along line 52.

Although specific embodiments of the invention have been described and illustrated it will be apparent to one skilled in the art that various changes can be made to these embodiments. It is to be understood that such changes are considered to be within the scope of the invention as set out in the appended claims.

## Claims

1. A method of manufacturing a substrate having isolated metal pads comprising the steps of:
a) forming a first channel into the top surface of a plate of substrate material;
b) depositing a metal layer on the top surface and in said first channel;
c) forming at least a second channel into the top surface of said plate, said at least a second channel crossing said first channel and to a depth into said plate which is greater than the depth of said first channel; and
d) separating said substrate from said plate of substrate material.

2. A method as defined in claim 1 wherein said channels are formed by sawing.

3. A method as defined in claim 1 wherein said channels are formed by a diamond blade.

4. A method as defined in claim 3 wherein a plurality of diamond blades are ganged with a predetermined spacing.

5. A method as defined in claim 1 wherein said metal is deposited by sputtering.

6. A method as defined in claim 4 wherein a plurality of said substrates are formed in a plate of substrate material.

7. A bi-level substrate having isolated metal pads, said substrate having: a top surface, a bottom surface and opposed side walls, one of said side walls having a lateral step with an upper surface substantially parallel to said substrate top surface; a channel perpendicular to said lateral step and extending from said top surface to a plane below the upper surface of said lateral step; and a metal layer on said top surface, on said upper surface of said lateral step and on said side wall therebetween.

8. A bi-level substrate as defined in claim 7 wherein said substrate material is ceramic.

9. A bi-level substrate as defined in claim 8 wherein said metal is a deposited gold alloy.

10. A bi-level substrate as defined in claim 7 having a second channel in said top surface, said second channel being perpendicular to said first channel and of sufficient depth to extend through said metal layer.

11. A bi-level substrate as defined in claim 7 having a plurality of channels perpendicular to said lateral step to form a plurality of isolated metal pads.

12. A bi-level substrate as defined in claim 10 having a plurality of channels perpendicular to said lateral step.
